Europäisches Patentamt

European Patent Office

Office européen des brevets

(19)

(11) Veröffentlichungsnummer: **0 008 674**
**B1**

(12) **EUROPÄISCHE PATENTSCHRIFT**

(45) Veröffentlichungstag der Patentschrift:
15.06.83

(21) Anmeldenummer: **79102736.0**

(22) Anmeldetag: **31.07.79**

(51) Int. Cl.³: **H 03 H 15/02,** H 03 H 19/00,
H 01 L 27/10

(54) Integrierte Filterschaltung.

(30) Priorität: 31.08.78 DE 2838096

(43) Veröffentlichungstag der Anmeldung:
19.03.80 Patentblatt 80/6

(45) Bekanntmachung des Hinweises auf die Patenterteilung:
15.06.83 Patentblatt 83/24

(84) Benannte Vertragsstaaten:
BE FR GB IT NL

(73) Patentinhaber: SIEMENS AKTIENGESELLSCHAFT,
Berlin und München Wittelsbacherplatz 2,
D-8000 München 2 (DE)

(72) Erfinder: Pfleiderer, Hans-Jörg, Dr.,
Franz-Krinninger-Weg 23, D-8011 Zorneding (DE)

(56) Entgegenhaltungen:
CONFERENCE RECORD 1978 INTERNATIONAL CONFERENCE ON COMMUNICATIONS; Band 3 (IEEE catalog Nr. 78CH1350-8 CSCB), Toronto, CA; Juni 4—7, 1978, New York, US M.A. COPELAND: »Some aspects of sampled-analog MOS LSI circuits for communication«, Seiten 45.1.1—45.1.7.
DER ELEKTRONIKER, Band 15, Nr. 7, Juli 1976, Aarau, CH O. MÜLLER: »Halbleiterfilter auf einem Chip«, Seiten EL5 bis EL11.

WISSENSCHAFTLICHE BERICHTE AEG TELE-FUNKEN, Band 52, Nr. 1—2, Jan./Febr. 1979 Berlin DE P. CHRISTIANSEN et al. »Integration von Filtern mit linearen MOS-Schaltungen«, Seiten 131—138.
ARCHIV FÜR ELEKTRONIK UND ÜBERTRA-GUNGSTECHNIK, Band 32, Nr. 10, Oktober 1978, Stuttgart, DE E. LUDER: »Integrierbare Filter in VLSI-Technik«, Seiten 381—389.

## Integrierte Filterschaltung

Die Erfindung bezieht sich auf eine integrierte Filterschaltung nach dem Oberbegriff des Patentanspruchs 1.

Die bei jedem Transversalfilter vorgenommene periodische zeitdiskrete Abtastung der eingangsseitig anliegenden Signale führt zu Störungen, die darauf zurückzuführen sind, daß eingangsseitige Störsignale, deren Frequenz sich um den Abstand der Taktfrequenz des Transversalfilters oder eines Vielfachen davon von dem Frequenzbereich des zu filternden Nutzsignals unterscheidet, zu dem Ausgang des Filters übertragen werden und eine Verfälschung des Filterausgangssignals bewirken. Um diesem Einfluß, der im englischen Sprachgebrauch als »aliasing« bezeichnet wird, zu begegnen, ist es bekannt, dem Eingang des Transversalfilters einen Tiefpaß vorzuschalten, der die durch die Taktfrequenz und ihre Oberschwingungen bestimmten Frequenzbereiche, in denen Übertragungen solcher Störsignale vorkommen, weitgehend bedämpft.

Dabei ist es jedoch nachteilig, daß RC-Vorschalt-Tiefpässe, die beispielsweise in dem Aufsatz »Antialiasing Inputs for Charge-Coupled Devices« von C. H. Séquin in dem IEEE-Journal of Solid State Circuits, Vol. SC-12, No. 6, Dez. 1977, Seiten 609 bis 616, insbesondere Seite 609, rechte Spalte, letzter Absatz, für diesen Zweck erwähnt werden, in integrierter Schaltungstechnik nicht ohne weiteres realisierbar sind, wenn Grenzfrequenzen im Bereich von einigen kHz angestrebt werden. Da nämlich die obere Grenze für Kapazitäten, die in integrierter Schaltungstechnik hergestellt und zusammen mit dem CTD-Transversalfilter auf einem Chip angeordnet sein sollen, im allgemeinen bei einigen pF liegt, müßten genaue Filterwiderstände in der Größenordnung von $G\Omega$ verwendet werden, um derartige Grenzfrequenzen zu erreichen.

In dem »Conference Record« der »1978 International Conference on Communications«, Bd. 3, IEEE Catalog Nr. 78ch 1350-8 CSCB, Toronto, Canada, 4. bis 7. Juni 1978, Seiten 45.1.1 bis 45.1.7 wird in Fig. 8 ein Tiefpaßfilter angegeben, das zwei Kondensatoren aufweist, von denen der eine kleiner ist als der andere, sowie zwei alternierend betätigbare elektronische Schalter, wobei über den einen Schalter ein Umladestromkreis für den einen Kondensator und über den anderen ein Umladestromkreis für eine aus den beiden Kondensatoren gebildete Serienschaltung verläuft. Dieses Tiefpaßfilter dient als Ersatz eines herkömmlichen RC-Tiefpaßfilters. Es ist weiterhin zur Herstellung einer integrierten Filterschaltung geeignet, wie dieser Veröffentlichung entnommen werden kann.

Der vorliegenden Erfindung liegt die Aufgabe zugrunde, eine Filterschaltung der eingangs genannten Art anzugeben, die auch bei relativ niedrigen Werten der Grenzfrequenz des Vorschaltfilters einfach und platzsparend realisiert werden kann. Das wird gemäß der Erfindung durch die im kennzeichnenden Teil des Patentanspruchs 1 angegebenen Maßnahmen erreicht. In den Ansprüchen 2 bis 8 sind vorteilhafte Weiterbildungen der erfindungsgemäßen Filterschaltung angegeben.

Der mit der Erfindung erzielbare Vorteil liegt insbesondere darin, daß das Vorschaltfilter in einfacher und kostensparender Weise mit dem CTD-Transversalfilter monolithisch integrierbar ist und daß bei einem geringen Bedarf an Halbleiterfläche Werte der Grenzfrequenz erreichbar sind, die bei einigen kHz liegen. Die Störanfälligkeit des CTD-Transversalfilters wird durch das erfindungsgemäße Vorschaltfilter weitgehend herabgesetzt.

Die Erfindung wird nachfolgend anhand der Zeichnung näher erläutert. Dabei zeigt

Fig. 1 in Verbindung mit Fig. 3 eine Prinzipdarstellung eines bevorzugten Ausführungsbeispiels der Erfindung,

Fig. 2 eine alternative Ausführungsform zu einer Teilschaltung von Fig. 1,

Fig. 3 eine Weiterbildung einer Teilschaltung von Fig. 1,

Fig. 4 eine bevorzugte Ausführungsform einer in den Fig. 1 und 3 enthaltenen Verstärkerschaltung und

Fig. 5 eine Schaltungsvariante zu Fig. 4.

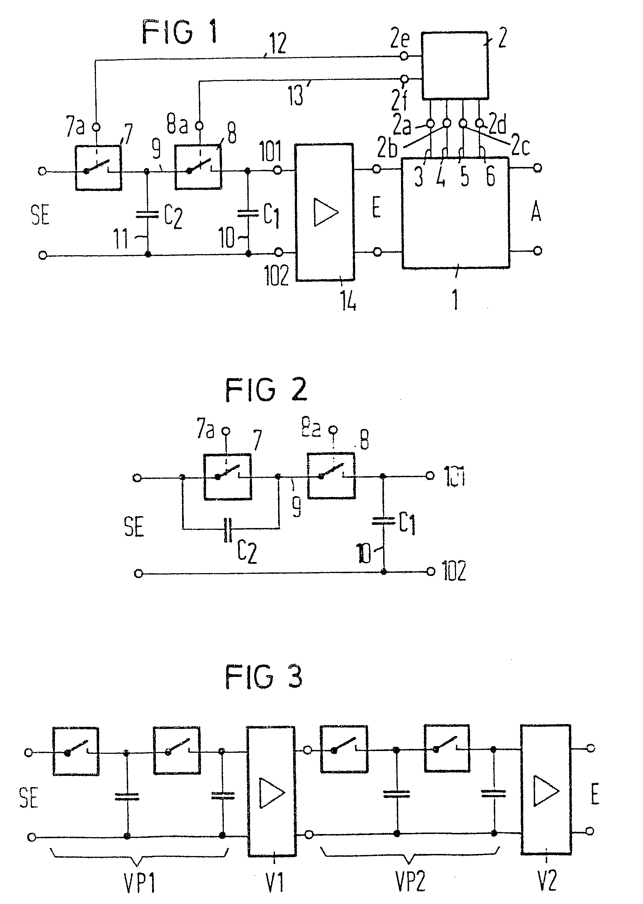

In Fig. 1 stellt der Block 1 ein an sich bekanntes CTD-Transversalfilter dar, wie es beispielsweise in dem Buch von Séquin und Tompsett »Charge Transfer Devices«, Academic Press, New York, 1975, auf den Seiten 216 bis 232 beschrieben ist. Andere Ausführungsformen von CTD-Transversalfiltern, die hierunter ebenfalls verstanden sein sollen, sind dem Aufsatz »CTD-Transversalfilter with Parallel-In/Serial-Out Configuration« von K. Knauer, H.-J. Pfleiderer und H. Keller in den Siemens-Forschungs- und Entwicklungs-Berichten, Band 7, 1978, Nr. 3, Seiten 1 bis 5, entnehmbar. Der Signaleingang des Transversalfilters ist mit E, der Filterausgang mit A bezeichnet. Ein Taktspannungsgenerator 2 weist Ausgänge 2a bis 2d auf, an denen gleichfrequente, gegeneinander phasenverschobene Taktspannungen $\Phi_1$ bis $\Phi_4$ abgreifbar sind, die über Leitungen 3 bis 6 den Verschiebeelektroden einer im einzelnen nicht dargestellten Ladungsverschiebeanordnung (CTD), die einen wesentlichen Bestandteil des Transversalfilters 1 darstellt, in herkömmlicher Weise zugeführt werden.

Zwischen einem mit SE bezeichneten Schaltungseingang und dem Eingang E des CTD-Transversalfilters 1 ist ein weiteres, als Tiefpaß ausgebildetes Filter vorgesehen, das nach der Erfindung einen ersten Kondensator $C_1$, einen zweiten, wesentlich kleineren Kondensator $C_2$ und zwei alternierend betätigbare elektronische Schalter 7 und 8 aufweist. Dabei sind diese Schaltelemente zu einer Vierpolschaltung zusammengefaßt, deren Eingang mit dem Schaltungseingang SE zusammenfällt und deren Ausgang durch die Schaltungspunkte 101 und 102 gebildet wird. Die Schalter 7 und 8 sind in Serie zueinander im Längszweig 9 dieser Vierpolschaltung vorgesehen, während der erste Kondensator $C_1$ in einen ausgangsseitigen Querzweig 10 und der zweite Kondensator $C_2$ in einen zwischen den Schaltern 7 und 8 angeschalteten Querzweig 11 eingefügt sind.

Der Taktspannungsgenerator 2 besitzt weitere Ausgänge 2e und 2f, an denen zwei gleichfrequente, gegeneinander phasenverschobene Taktspannungen abgreifbar sind, die den Steuereingängen 7a und 8a der Schalter 7 und 8 über Leitungen 12 und 13 zugeführt werden.

Die zwischen den Schaltungspunkten SE, 101 und 102 liegende Vierpolschaltung ist an sich aus dem »IEEE Journal of Solid State Circuits, Vol. SC-12, No. 6, Dez. 1977, Seiten 592 bis 599, insbesondere Fig. 1 und 2, bekannt. Wie auch aus der Beschreibung zu den genannten Figuren dieser Veröffentlichung hervorgeht, findet bei einer alternierenden Betätigung der Schalter 7 und 8, wobei zunächst 7 geschlossen wird und 8 offenbleibt, während anschließend 7 öffnet und 8 schließt, zunächst eine Aufladung von $C_2$ auf die Amplitude eines bei SE anliegenden Signals statt, während anschließend die Kondensatoren $C_1$ und $C_2$ über den Längszweig 9 und die Querzweige 10 und 11 in einen Stromkreis eingeschaltet werden, in dem sie in Serie zueinander liegen, so daß eine teilweise Übertragung der Ladung von $C_2$ auf $C_1$ erfolgen kann.

Unter der Annahme, daß die Kapazität von $C_1$ wesentlich größer ist als die von $C_2$ — als Beispiel hierfür sei ein Größenverhältnis von 100 : 1 genannt — und eine periodische Betätigung der Schalter 7 und 8 mit einer Periode T erfolgt, simuliert die Vierpolschaltung ein RC-Tiefpaßfilter mit einem ohmschen Widerstand R im Längszweig 9 und dem Kondensator $C_1$ im Querzweig 10, wobei der Wert von R dem Quotienten $T/C_2$ entspricht. Hierbei ist unter $C_2$ die Kapazität des Kondensators $C_2$ zu verstehen. Wählt man die Periode T zu 1 µs, was einer Taktfrequenz der den Schaltern 7 und 8 zugeführten Taktspannungen von 1 MHz entspricht, und bemißt die Kondensatoren $C_1$ und $C_2$ derart, daß ihre Kapazitäten im Verhältnis von 100 : 1 stehen, so ergibt sich bei einer Kapazität von 0,1 pF für den Kondensator $C_1$ im Längszweig 9 der Vierpolschaltung ein äquivalenter ohmscher Widerstand von 10 MΩ und für das Tiefpaßfilter eine Grenzfrequenz von etwa 1 kHz. Bei einem CTD-Transversalfilter 1, das mit einer Taktfrequenz von 16 kHz betrieben wird, stellt das bereits eine deutliche Verbesserung der Filtereigenschaften im Hinblick auf das eingangs erwähnte »aliasing«-Verhalten dar.

Zwischen die Schaltungspunkte 101 und 102 ist ein Verstärker 14 mit einem hochohmigen Eingangswiderstand geschaltet, wie in Fig. 1 angedeutet ist.

Fig. 2 zeigt eine andere Ausführungsform der Vierpolschaltung, die anstelle der oben beschriebenen in Fig. 1 einzusetzen ist. Die bereits anhand von Fig. 1 beschriebenen Schaltungsteile und Anschlußpunkte sind in Fig. 2 mit den gleichen Bezugszeichen versehen. Zum Unterschied von Fig. 1 ist der Kondensator $C_2$ nunmehr dem Schalter 7 parallel geschaltet. Damit ergibt sich in der ersten · Schaltphase, in der der Schalter 7 geschlossen ist, während der Schalter 8 geöffnet bleibt, eine Entladung von $C_2$ über den Schalter 7, während in der zweiten Schaltphase (7 geöffnet, 8 geschlossen) ein Ladekreis für die aus $C_1$ und $C_2$ gebildete Serienschaltung hergestellt wird, dessen Anschlüsse SE an einer Spannung liegen, die durch den Amplitudenwert eines anliegenden Eingangssignals gegeben ist. Unter der Voraussetzung, daß $C_1$ eine wesentlich größere Kapazität aufweist als $C_2$, gilt die bereits anhand von Fig. 1 dargelegte Beziehung, nach der der Längszweig 9 einen ohmschen Widerstand simuliert, dessen Wert dem Quotienten $T/C_2$ entspricht, wobei T die Periode der die Schalter 7 und 8 betätigenden Taktspannungen und $C_2$ die Kapazität des Kondensators $C_2$ bedeuten.

Die Störanfälligkeit der integrierten Filterschaltung nach der Erfindung ist dadurch stark herabgesetzt, daß zwischen dem Schaltungseingang SE und dem Eingang E des Transversalfilters von Fig. 1 anstelle einer einzigen Vierpolschaltung eine Kaskadenschaltung aus mehreren solchen Schaltungen, von denen jede durch einen ausgangsseitigen Verstärker mit hohem Eingangswiderstand ergänzt ist, vorgesehen wird. In Fig. 3 ist eine zweistufige Kaskadenschaltung dieser Art dargestellt, wobei die einzelnen Vierpolschaltungen mit VP1 und VP2 bezeichnet sind, die abschließenden Verstärker mit V1 und V2. Selbstverständlich können die Vierpole VP1 und VP2 auch gemäß Fig. 2 ausgebildet sein. Der Verstärker V2 von Fig. 3 entspricht dabei dem Verstärker 14 nach Fig. 1.

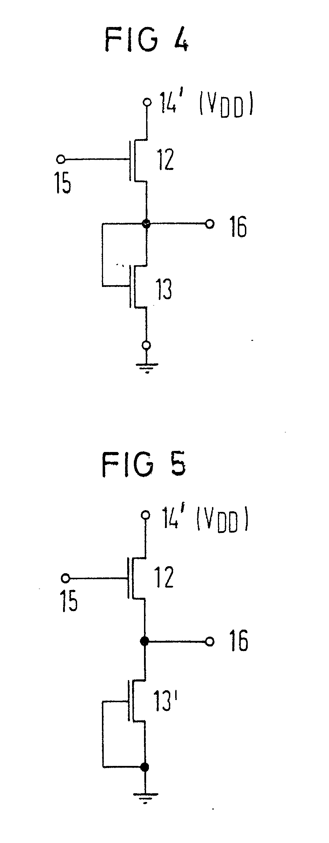

Fig. 4 zeigt eine bevorzugte Ausführungsform der Verstärker 14, V1 und V2, die als eine mit MIS-Feldeffekttransistoren bestückte Source-Folger-Stufe aufgebaut ist. Dabei sind zwei Feldeffekttransistoren 12 und 13 vom Anreicherungstyp mit ihren Source-Drain-Strecken in Serie geschaltet, wobei der Drainanschluß von 12 mit einem die Versorgungsspannung $V_{DD}$ führenden Anschluß 14' verbunden ist, während der Sourceanschluß von 13 mit Massepotential beschaltet ist. Der Gateanschluß 15 des Transistors 12 bildet den Verstärkereingang, während der Verstärkerausgang 16 an den Sourceanschluß des Transistors 12 gelegt ist. Der Gateanschluß des ein Lastelement darstellenden Transistors 13 ist mit seinem Drainanschluß verbunden.

Eine Schaltungsvariante zu Fig. 4 ist in Fig. 5 gezeigt. Hierbei ist anstelle des Transistors 13 ein Transistor 13' vom Verarmungstyp vorgesehen, dessen Gate mit seinem Sourceanschluß verbunden ist, um ein Lastelement zu realisieren.

Die elektronischen Schalter 7 und 8 können mit Vorteil als Feldeffekt-Schalttransistoren realisiert werden, deren isolierte Gateelektroden an die Steuereingänge 7a und 8a geführt sind. Ein besonders günstiges und störfreies Betriebsverhalten ergibt sich für die Filterschaltung nach der Erfindung, wenn die Frequenz der den Steuereingängen 7a und 8a zugeführten Taktspannungen ein ganzzahliges Vielfaches der Frequenz der dem CTD-Transversalfilter zugeführten Verschiebetaktspannungen darstellt.

## Patentansprüche

1. Integrierte Filterschaltung mit einem CTD-Transversalfilter (1) und einem als Tiefpaß ausgebildeten, weiteren Filter, das dem Transversalfilter vorgeschaltet ist, dadurch gekennzeichnet, daß das weitere Filter als mehrstufiges Filter ausgebildet ist, daß jede Stufe des vorgeschalteten Filters einen ersten Kondensator ($C_1$), einen zweiten, wesentlich kleineren Kondensator ($C_2$), zwei alternierend betätigbare elektronische Schalter (7, 8) und einen ausgangsseitigen Verstärker mit hohem Eingangswiderstand aufweist, dessen Eingang dem ersten Kondensator ($C_1$) parallel geschaltet ist, und daß über den einen Schalter jeder Stufe (7) ein Umladestromkreis für den zweiten Kondensator ($C_2$) und über den anderen Schalter (8) jeder Stufe ein Umladestromkreis (9, 10, 11) für eine aus beiden Kondensatoren ($C_1$, $C_2$) gebildete Serienschaltung verläuft.

2. Filterschaltung nach Anspruch 1, dadurch gekennzeichnet, daß eine Stufe des weiteren Filters aus einem Vierpol besteht, in dessen Längszweig (9) beide Schalter (7, 8) in Serie zueinander angeordnet sind, und daß der erste Kondensator ($C_1$) in einen ausgangsseitigen Querzweig (10) und der zweite Kondensator ($C_2$) in einen zwischen den Schaltern (7, 8) angeordneten Querzweig (11) eingefügt sind.

3. Filterschaltung nach Anspruch 1, dadurch gekennzeichnet, daß eine Stufe des weiteren Filters aus einem Vierpol besteht, in dessen Längszweig (9) der zweite Schalter (8) in Serie zu einer Parallelschaltung aus dem ersten Schalter (7) und dem zweiten Kondensator ($C_2$) angeordnet ist, und daß der erste Kondensator ($C_1$) in einen ausgangsseitigen Querzweig (10) eingefügt ist.

4. Filterschaltung nach einem der Ansprüche 1 bis 3, dadurch gekennzeichnet, daß der Verstärker (14, V1, V2) mit hochohmigem Eingangswiderstand aus einer in MIS-Technik aufgebauten Source-Folger-Stufe (12, 13) besteht.

5. Filterschaltung nach einem der vorhergehenden Ansprüche, dadurch gekennzeichnet, daß ein Taktspannungsgenerator (2) vorgesehen ist, der Ausgänge (2e, 2f) für zwei gegeneinander phasenverschobene erste Taktspannungen aufweist, die mit Steuereingängen (7a, 8a) der elektronischen Schalter (7, 8) verbunden sind, sowie weitere Ausgänge (2a bis 2d) für zweite, eine niedrigere Frequenz aufweisende Taktspannungen ($\Phi_1$ bis $\Phi_4$), die zum Betrieb des CTD-Transversalfilters (1) dienen.

6. Filterschaltung nach Anspruch 5, dadurch gekennzeichnet, daß die Frequenz der ersten Taktspannungen ein ganzzahliges Vielfaches der Frequenz der zweiten Taktspannungen ($\Phi_1$ bis $\Phi_4$) ist.

## Claims

1. An integrated filter circuit comprising a CTD transversal filter (1) and a further filter designed as a low-pass filter and connected preceding the transversal filter, characterised in that the further filter is designed as a multi-stage filter, that each stage of the preceding filter has a first capacitor ($C_1$), a second, substantially smaller capacitor ($C_2$), two electronic switches (7, 8) actuated in alternation, and a high input resistance amplifier at the output end, whose input is connected parallel to the first capacitor ($C_1$), and that a transfer circuit for the second capacitor ($C_2$) runs via the one switch of each stage (7) and a transfer circuit (9, 10, 11) for a series connection consisting of both capacitors ($C_1$, $C_2$) runs via the other switch (8) of each stage.

2. A filter circuit as claimed in Claim 1, characterised in that one stage of the further filter consists of a quadripole in whose longitudinal branch (9), both switches (7, 8) are arranged in series to one another, and that the first capacitor ($C_1$) is inserted into a transverse branch (10) at the output end and the second capacitor ($C_2$) is inserted into a transverse branch (11) arranged between the switches (7, 8).

3. A filter circuit as claimed in Claim 1, characterised in that one stage of the further filter consists of a quadripole, in whose longitudinal branch (9), the second switch (8) is arranged in series to a parallel circuit consisting of the first switch (7) and the second capacitor ($C_2$), and that the first capacitor ($C_1$) is inserted into a transverse branch (10) at the output end.

4. A filter circuit as claimed in one of Claims 1 to 3, characterised in that the amplifier (14, V1, V2) having a high input resistance consists of a source-follower-stage (12, 13) constructed in MIS-technology.

5. A filter circuit as claimed in one of the preceding Claims, characterised in that there is provided a pulse voltage generator (2) which possesses outputs (2e, 2f) for two first pulse voltages which are phase-shifted relative to one another and connected to control inputs (7a, 8a) of the electronic switches (7, 8), and which possesses further outputs (2a to 2d) for second pulse voltages ($\Phi_1$ to $\Phi_4$) which have a low frequency and which serve for the operation of the CTD-transversal filter (1).

6. A filter circuit as claimed in Claim 5, characterised in that the frequency of the first pulse voltages is an integral multiple of the frequency of the second pulse voltages ($\Phi_1$ to $\Phi_4$).

## Revendications

1. Circuit de filtrage avec un filtre transversal CTD (1) et un second filtre réalisé sous la forme d'un passe-bas et monté en amont du filtre transversal, caractérisé par le fait que le second filtre est réalisé sous la forme d'un filtre à plusieurs étages, que chaque étage du filtre amont comporte un premier condensateur ($C_1$), un second condensateur ($C_2$) notablement plus petit, deux commutateurs électroniques (7, 8) susceptibles d'être commandés alternativement et un amplificateur de sortie à forte résistance d'entrée, dont l'entrée est branchée en parallèle sur le condensateur ($C_1$) et que par le premier commutateur de chaque étage (7) passe un circuit d'inversion de charge pour le second condensateur ($C_2$) et par l'autre commutateur (8) de chaque étage passe un circuit d'inversion de charge (9, 10, 11) pour un circuit série constitué par les deux condensateurs ($C_1$, $C_2$).

2. Circuit de filtrage selon la revendication 1, caractérisé par le fait qu'un étage du second filtre est constitué par un quadripole dans la branche longitudinale duquel sont disposés en série entre eux les deux commutateurs (7, 8), et que le premier condensateur ($C_1$) est monté dans une branche transversale (10) située du côté sortie, alors que le second condensateur ($C_2$) est monté dans une branche transversale 11) disposée entre les commutateurs (7, 8).

3. Circuit de filtrage selon la revendication 1, caractérisé par le fait qu'un étage du second filtre est constitué par un quadripole dans la branche longitudinale (9) duquel est monté le second commutateur (8), en série avec un circuit parallèle constitué par le premier commutateur (7) et le second condensateur ($C_2$), et que le premier condensateur ($C_1$) est inséré dans une branche transversale (10) située du côté sortie.

4. Circuit de filtrage selon l'une des revendications 1 à 3, caractérisé par le fait que l'amplificateur (14, V1, V2) à résistance d'entrée fortement ohmique, est constitué par un étage à source suiveuse, constitué en technique MIS.

5. Circuit de filtrage selon l'une des revendications précédentes, caractérisé par le fait qu'il est prévu un générateur de tensions de cadence (2) qui comporte des sorties (2e, 2f), pour deux premières tensions de cadence déphasées l'une par rapport à l'autre, qui sont reliées avec des entrées de commande (7a, 8a) des commutateurs électroniques (7, 8), ainsi que deux autres sorties (2a à 2d) pour les secondes tensions de cadence ($\Phi_1$ à $\Phi_4$) présentant une fréquence faible et qui servent à commander le filtre transversal CTD (1).

6. Circuit de filtrage selon la revendication 5, caractérisé par le fait que la fréquence des premières tensions de cadence est un multiple entier de la fréquence des secondes tensions de cadence ($\Phi_1$ à $\Phi_4$).

## FIG 1

## FIG 2

## FIG 3

# FIG 4

○ 14' (V$_{DD}$)

12

15

○ 16

13

# FIG 5

○ 14' (V$_{DD}$)

12

15

○ 16

13'